# EUROPEAN PATENT APPLICATION

(11) **EP 4 750 290 A1**
(43) Date of publication of application: **27.05.2026**
(21) Application number: 25195520.9
(22) Date of filing: 12.08.2025
(51) Int. Cl.: H10K 59/35, H10K 59/122

(54) **ORGANIC LIGHT EMITTING DISPLAY APPARATUS**

(30) Priority: 25.11.2024 KR 20240169796
(71) Applicant: LG Display Co., Ltd., Seoul, 07336 (KR)
(72) Inventor: GONG, Hyojoon, 10845 Paju-si (KR)
(74) Representative: Finlayson, Scott Henry

(57) **Abstract**

An organic light emitting display apparatus is disclosed, including a substrate having a plurality of subpixels; a pixel defining layer on the substrate and defining a light emitting opening; a partition wall on the pixel defining layer and defining a partition wall opening corresponding to the light emitting opening; and a light emitting element corresponding to the partition wall opening. The partition wall opening includes a center opening, a first partition wall opening extending in a first direction from the center opening, a second partition wall opening extending in a second direction overlapping the first direction, and a third partition wall opening extending in a third direction overlapping both the first and second directions. The plurality of subpixels is respectively disposed in the first, second, and third partition wall openings, enabling separation and arrangement of subpixels within a shared structure for efficient light emission without using a fine metal mask.

## Description

### CROSS-REFERENCE TO RELATED APPLICATIONS

This application claims the benefit of priority of the Korean Patent Application No. 10-2024-0169796 filed on November 25, 2024, which is hereby incorporated by reference as if fully set forth herein.

### BACKGROUND

### Technical Field

The present disclosure relates to an organic light emitting display apparatus.

### Description of the Related Art

As the information society develops, interest in display devices for displaying images and the demand for using them are increasing in various forms, and the display field has been developing rapidly, and in response, various lightweight and thin flat panel display devices have been developed and are receiving attention. Recently, display devices such as liquid crystal display devices and organic light emitting display devices are being utilized.

Organic light emitting display apparatus are self-luminous display devices, and display images on a display panel by emitting light from an organic light emitting layer sandwiched between two electrodes. Unlike liquid crystal displays, they do not require a separate light source such as a backlight unit, and can thus be manufactured as lightweight and thin. In addition, organic light emitting display apparatus is advantageous in terms of power consumption due to low-voltage operation, and are also excellent in color implementation, response speed, viewing angle, and contrast ratio, and are thus attracting attention as next-generation display devices.

An organic light emitting display apparatus includes pixels, each pixel including a light emitting element, and banks that partition the pixels to define the pixels. The banks can serve as pixel defining layers.

Each of the pixels may have a red pixel including a red organic light emitting layer that emits red light, a green pixel including a green organic light emitting layer that emits green light, and a blue pixel including a blue light emitting layer that emits blue light. In this case, a red organic light emitting layer may be formed in the red pixels using a fine metal mask (hereinafter referred to as "FMM") in which an opening is formed in an area corresponding to the red pixels, a green organic light emitting layer may be formed in the green pixels using the FMM in which an opening is formed in an area corresponding to the green pixels, and a blue organic light emitting layer may be formed in the blue pixels using the FMM in which an opening is formed in an area corresponding to the blue pixels.

### BRIEF SUMMARY

It has been recognized that when an organic light emitting layer is formed using a fine metal mask (FMM), reduced precision of the mask can lead to interference between subpixels, resulting in degraded color expression. Accordingly, the present disclosure provides various approaches for forming organic light emitting layers without the use of a fine metal mask (FMM).

The disclosed organic light emitting display apparatus uses geometrically structured partition walls to physically separate subpixels, eliminating the need for fine metal masks. These partition walls include a central region with three extensions oriented in different directions, allowing red, green, and blue subpixels to be formed independently through directional material deposition. This configuration enables accurate placement of organic light emitting layers, avoids color mixing, and reduces alignment errors commonly associated with mask-based methods.

The apparatus further includes a multilayer partition wall structure with controlled width and composition to improve precision and enhance optical and electrical performance. By arranging subpixels more closely within a compact area and providing separate electrodes for each, the design supports independent subpixel operation and achieves higher pixel density and improved color accuracy, which are advantageous for high-resolution display applications.

One embodiment of the present disclosure is to provide an organic light emitting display apparatus that forms a light emitting layer using a partition instead of an FMM.

One embodiment of the present disclosure is to provide an organic light emitting display apparatus in which a large number of subpixels are disposed within the same area by reducing the spacing between subpixels.

In order to achieve the above-described technical problem, one embodiment of the present disclosure provides an organic light emitting display apparatus, including: a substrate having a plurality of subpixels; a pixel defining layer disposed on the substrate and defining a light emitting opening; a partition wall disposed on the pixel defining layer and defining a partition wall opening corresponding to the light emitting opening; and a light emitting element corresponding to the partition wall opening, wherein the partition wall opening includes: a center opening; a first partition wall opening disposed to extend in a first direction from the center opening; a second partition wall opening disposed to extend in a second direction intersecting the first direction from the center opening; and a third partition wall opening disposed to extend in a third direction intersecting the first direction and the second direction from the center opening, respectively, wherein the plurality of subpixels are disposed in the first partition wall opening, the second partition wall opening, and the third partition wall opening, respectively.

The light emitting element includes an anode electrode; a light emitting layer on the anode electrode; and a cathode electrode on the light emitting layer, wherein the light emitting layer is in contact with a side surface of the pixel defining layer, and the cathode electrode can cover an upper surface of the pixel defining layer.

The plurality of subpixels may include a first subpixel, a second subpixel, and a third subpixel, and the light emitting element may include a first light emitting element including a first anode electrode and disposed in the first subpixel; a second light emitting element including a second anode electrode and disposed in the second subpixel; and a third light emitting element including a third anode electrode and disposed in the third subpixel.

The first anode electrode is disposed in the first partition wall opening, the second anode electrode is disposed in the second partition wall opening, the third anode electrode is disposed in the third partition wall opening, and the first anode electrode, the second anode electrode, and the third anode electrode can be disposed spaced apart from each other.

The plurality of subpixels may not be disposed in the center opening.

The width of the light emitting opening may be smaller than the width of the partition wall opening.

The partition wall may include a first partition wall defining a lower partition wall opening; and a second partition wall defining an upper partition wall opening having a narrower width than the lower partition wall opening and disposed on the first partition wall.

The partition wall may include a first partition wall defining a lower partition wall opening; and a second partition wall defining an upper partition wall opening having the same width as the lower partition wall opening and disposed on the first partition wall.

The first partition wall and the second partition wall may each include any one of gold (Au), silver (Ag), aluminum (Al), magnesium (Mg), lithium (Li), molybdenum (Mo), titanium (Ti), copper (Cu), or an alloy thereof.

The thickness of the first partition wall may be greater than or equal to 1000 Angstroms and less than or equal to 2500 Angstroms, and the thickness of the second partition wall may be greater than or equal to 500 Angstroms and less than or equal to 1000 Angstroms.

The light emitting element includes an anode electrode; a light emitting layer on the anode electrode; and a cathode electrode on the light emitting layer, wherein the width of the anode electrode may be narrower than the width of the lower partition wall opening and wider than the width of the upper partition wall opening.

The center opening may have a Y shape in a plan view.

The first partition wall opening, the second partition wall opening, and the third partition wall opening may have a circularly protruding shape from the center opening in a plan view.

The first partition wall opening, the second partition wall opening, and the third partition wall opening may have a polygonally protruding shape from the center opening in a plan view.

The center opening may have a triangular shape in a plan view.

The first partition wall opening, the second partition wall opening, and the third partition wall opening may have a circularly protruding shape from vertices of the triangular shape in a plan view.

The first partition wall opening, the second partition wall opening, and the third partition wall opening may have a shape that protrudes in a polygonal shape from the vertices of the triangular shape in a plan view.

### BRIEF DESCRIPTION OF THE SEVERAL VIEWS OF THE DRAWINGS

The above and other objects, features and other advantages of the present disclosure will be more clearly understood from the following detailed description taken in conjunction with the accompanying drawings, in which:
FIG. 1 is a drawing for explaining an organic light emitting display apparatus according to one embodiment of the present disclosure.
FIG. 2 is a perspective view showing a portion of a display area of a display panel according to one embodiment of the present disclosure.
FIG. 3 is an enlarged plan view of a portion of a display area of a display panel according to one embodiment of the present disclosure.
FIG. 4 is a cross-sectional view taken along line I-I' of FIG. 3.
FIG. 5 is a cross-sectional view taken along line II-II' of FIG. 3.
FIG. 6 is an enlarged plan view of a portion of a display area of a display panel according to another embodiment of the present disclosure.
FIG. 7 is a cross-sectional view taken along line III-III' of FIG. 6.
FIG. 8 is an enlarged plan view of a portion of a display area of a display panel according to another embodiment of the present disclosure.

### DETAILED DESCRIPTION

Advantages and features of the present disclosure and implementation methods thereof will be clarified through following embodiments described with reference to the accompanying drawings. The present disclosure may, however, be embodied in different forms and should not be construed as limited to the embodiments set forth herein. Rather, these embodiments are provided so that this disclosure will be thorough and complete and will fully convey the scope of the present disclosure to those skilled in the art. Further, the present disclosure is only defined by scopes of claims.

The shapes, sizes, dimensions (e.g., length, width, height, thickness, radius, diameter, area, etc.), ratios, angles, number of elements, and the like illustrated in the accompanying drawings for describing the embodiments of the present disclosure are merely examples, and the present disclosure is not limited thereto.

A dimension including size and a thickness of each component illustrated in the drawing are illustrated for convenience of description, and the present disclosure is not limited to the size and the thickness of the component illustrated, but it is to be noted that the relative dimensions including the relative size, location, and thickness of the components illustrated in various drawings submitted herewith are part of the present disclosure.

Like reference numerals refer to like elements throughout the specification. In the following description, when the detailed description of the relevant known function or configuration is determined to unnecessarily obscure the important point of the present disclosure, the detailed description will be omitted.

In a case where 'comprise,' 'have' and 'include' described in the present disclosure are used, another portion may be added unless 'only~' is used. The terms of a singular form may include plural forms unless referred to the contrary.

In construing an element, the element is construed as including an error band although there is no explicit description.

In describing a position relationship, for example, when the position relationship is described as 'upon~,' 'above~,' 'below~' and 'next to~,' one or more portions may be disposed between two other portions unless 'just' or 'direct' is used.

Spatially relative terms such as "below," "beneath," "lower," "above," and "upper" may be used herein to easily describe a relationship of one element or elements to another element or elements as illustrated in the drawings. It will be understood that these terms are intended to encompass different orientations of the device in addition to the orientation depicted in the drawings. For example, if the device illustrated in the figure is reversed, the device described to be arranged "below," or "beneath" another device may be arranged "above" another device. Therefore, an exemplary term "below or beneath" may include "below or beneath" and "above" orientations. Likewise, an exemplary term "above" or "on" may include "above" and "below or beneath" orientations.

In describing a temporal relationship, for example, when the temporal order is described as "after," "subsequent," "next," and "before," a case which is not continuous may be included, unless "just" or "direct" is used.

It will be understood that, although the terms "first," "second," etc., may be used herein to describe various elements, these elements should not be limited by these terms. These terms are only used to distinguish one element from another. For example, a first element could be termed a second element, and, similarly, a second element could be termed a first element, without departing from the scope of the present disclosure.

As used herein, the term "connected" is intended to have the broadest possible meaning. Specifically, the phrase "A is connected to B" encompasses both a direct connectionwhere no intervening components or elements are present-and an indirect connection, where one or more intermediate components or elements exist between A and B. In other words, "A is connected to B" includes both direct physical or electrical coupling and indirect coupling through one or more intervening components. Unless explicitly stated otherwise, these terms do not require direct physical or electrical contact. The term "coupled" and "in contact" should be interpreted in the same manner.

It should be understood that the term "at least one" includes all combinations related with any one item. For example, "at least one among a first element, a second element and a third element" may include all combinations of two or more elements selected from the first, second and third elements as well as each element of the first, second and third elements.

Features of various embodiments of the present disclosure may be partially or overall coupled to or combined with each other and may be variously inter-operated with each other and driven technically as those skilled in the art can sufficiently understand. The embodiments of the present disclosure may be carried out independently from each other or may be carried out together in a co-dependent relationship.

In the addition of reference numerals to the components of each drawing describing embodiments of the present disclosure, the same components can have the same sign as can be displayed on the other drawings.

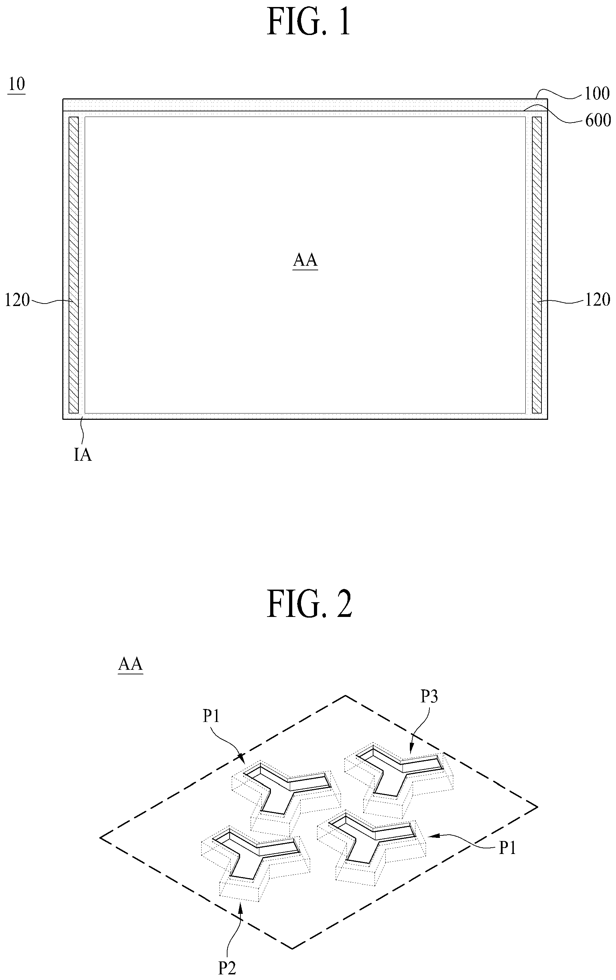

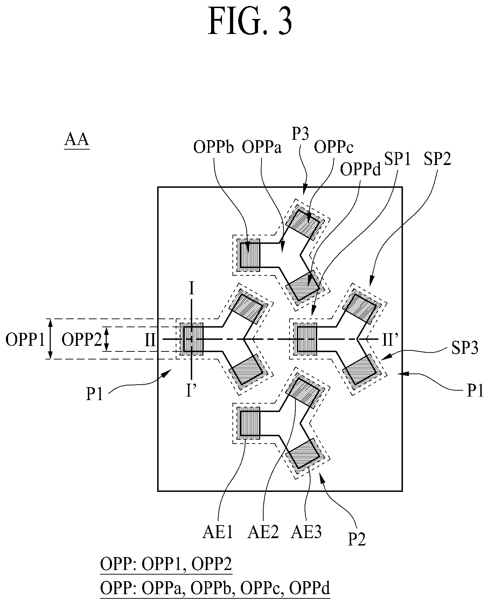

FIG. 1 is a drawing for explaining an organic light emitting display apparatus according to one embodiment of the present disclosure. FIG. 2 is a perspective view showing a part of a display area (AA) of a display panel (10) according to one embodiment of the present disclosure. FIG. 3 is an enlarged plan view of a part of a display area (AA) of a display panel (10) according to one embodiment of the present disclosure.

Referring to FIG. 1, an organic light emitting display apparatus according to one embodiment of the present disclosure may include a display panel (10) including a substrate (100) and a counter substrate (600) bonded to each other.

The substrate (100) may be a transparent glass substrate or a transparent plastic substrate. The substrate (100) may include a display area (AA) and a non-display area (IA).

The display area (AA) is an area where an image is displayed, and may be a pixel array area, an active area, a pixel array section, a display section, or a screen. The display area (AA) may include a plurality of pixels (P1, P2, P3). Fig. 2 illustrates a plurality of pixels (P1, P2, P3) disposed in the display area (AA).

Each of the plurality of pixels (P1, P2, P3) can include a plurality of subpixels (SP1, SP2, SP3). For example, the plurality of subpixels (SP1, SP2, SP3) can constitute a plurality of pixels (P1, P2, P3).

The non-display area (IA) is an area where an image is not displayed, and may be a peripheral circuit area, a signal supply area, an inactive area, or a bezel area. The non-display area (IA) may be configured to surround the display area (AA). The display panel (10) or the substrate (100) may further include a peripheral circuit unit (120) disposed in the non-display area (IA). The peripheral circuit unit (120) may include a gate driving circuit connected to a plurality of subpixels (SP1, SP2, SP3).

The counter substrate (600) may be configured to overlap the display area (AA). The counter substrate (600) may be bonded to the substrate (100) by using an adhesive (or transparent adhesive) to face the substrate (100) or may be disposed in such a way that an organic or inorganic material is laminated on the substrate (100). The counter substrate (600) may be an upper substrate, a second substrate, or an encapsulating substrate, and may correspond to encapsulating the substrate (100).

Referring to FIG. 3, in an organic light emitting display apparatus or display panel (10) according to one embodiment of the present disclosure, each of a plurality of pixels (P1, P2, P3) may include three subpixels (SP1, SP2, SP3).

For example, each of the plurality of pixels (P1, P2, P3) may include a first subpixel (SP1) for red, a second subpixel (SP2) for green, and a third subpixel (SP3) for blue. However, the present disclosure is not limited thereto. Each of the first to third subpixels (SP1 to SP3) may be configured to have different sizes (or areas).

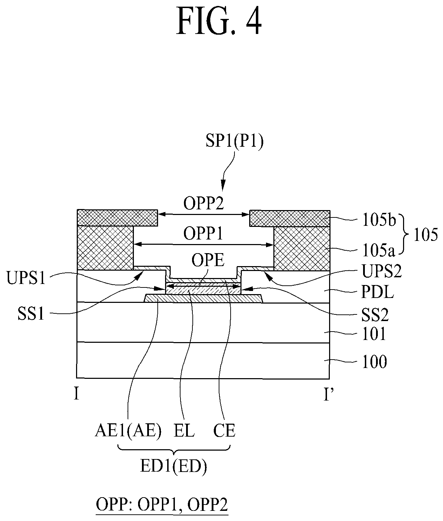

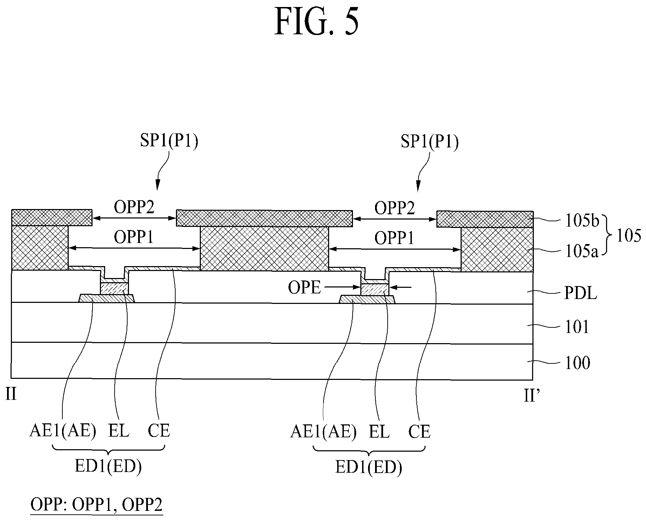

Fig. 4 is a cross-sectional view taken along line I-I' of Fig. 3. Fig. 5 is a cross-sectional view taken along line II-II' of Fig. 3.

Referring to FIGS. 4 and 5, the organic light emitting display apparatus may include a circuit element layer (101), a light emitting element (ED), a pixel defining layer (PDL), and a partition structure (105) (also referred to as 'a partition wall' (105); the partition structure may include at least one partition wall).

The circuit element layer (101) may be disposed on a substrate (100). The circuit element layer (101) may include a buffer layer, a thin film transistor, insulating layers, and a plurality of electrodes.

The buffer layer has insulating properties and protects the active layer of the transistor. The buffer layer may include at least one of silicon oxide (SiOx), silicon nitride (SiNx), and a metal oxide having insulating properties.

The thin film transistor can be disposed on a buffer layer. The thin film transistor includes an active layer, a gate electrode, a source electrode, and a drain electrode.

The insulating layers may be disposed on the thin film transistor. The insulating layers are for insulating the thin film transistor. The insulating layers may be formed of an inorganic film, such as a silicon oxide film (SiOx), a silicon nitride film (SiNx), or a multilayer thereof.

The plurality of electrodes may be disposed on the insulating layer. The plurality of electrodes may be connected to the thin film transistor by penetrating the insulating layers.

The light emitting element (ED) may include an anode electrode (AE), an emitting layer (EL), and a cathode electrode (CE). The anode electrode (AE) may be a first electrode or a pixel electrode, and the cathode electrode (CE) may be a second electrode or a common electrode.

The anode electrode (AE) may be disposed on the circuit element layer (101). The anode electrode (AE) may be a transparent electrode, a semi-transparent electrode, or a reflective electrode. The anode electrode (AE) may include a single layer or a multilayer structure.

The light emitting layer (EL) may be disposed on the anode electrode (AE). The light emitting layer (EL) may include a light emitting material layer including a light emitting material. The light emitting layer (EL) may further include a hole injection layer (HIL) and a hole transport layer (HTL) disposed between the anode electrode (AE) and the light emitting material layer, and may further include an electron transport layer (ETL) and an electron injection layer (EIL) disposed on the light emitting material layer. The light emitting layer (EL) may also be referred to as an 'organic layer' or an 'intermediate layer.'

The cathode electrode (CE) can be disposed on the light emitting layer (EL). The cathode electrode (CE) can be formed of a transparent metal material (TCO) such as ITO or IZO that can transmit light, or a semitransmissive metal material such as magnesium (Mg), silver (Ag), or an alloy of magnesium (Mg) and silver (Ag).

The pixel defining layer (PDL) may be disposed on a circuit element layer (101). A light emitting opening (OPE) may be defined by the pixel defining layer (PDL). The light emitting opening (OPE) may correspond to an anode electrode (AE) and expose a portion of the anode electrode (AE). Specifically, the pixel defining layer (PDL) may be disposed on the anode electrode (AE).

The pixel defining layer (PDL) may include an inorganic insulating material or an organic insulating material. For example, the pixel defining layer (PDL) may include at least one of silicon oxide (SiOx), silicon nitride (SiNx), and silicon oxynitride (SiOxNy). The pixel defining layer (PDL) may be disposed between the anode electrode (AE) and the partition wall (105), thereby blocking the anode electrode (AE) and the partition wall (105) from being electrically connected to each other.

The emitting layer (EL) of the light emitting element (ED) can be disposed between pixel defining layer (PDL). For example, the emitting layer (EL) can be in contact with a side surface (e.g., a first side surface SS1 and a second side surface SS2 opposite of the first side surface SS1) of the pixel defining layer (PDL). The emitting layer (EL) can correspond to a light emitting opening (OPE).

The cathode electrode (CE) of a light emitting element (ED) can cover an upper surface (e.g., a first upper surface UPS1 and a second upper surface UPS2 opposite of the first upper surface UPS 1) of a pixel defining layer (PDL). A part of the cathode electrode (CE) can be in contact with a side surface of the pixel defining layer (PDL), and another part can be in contact with an upper surface of the pixel defining layer (PDL).

The partition wall (105) may be disposed on the pixel defining layer (PDL). A partition wall opening (OPP) may be defined by the partition wall (105). The partition wall opening (OPP) may correspond to the light emitting opening (OPE) and may expose a portion of the anode electrode (AE). The light emitting element (ED) may correspond to the partition wall opening (OPP).

The partition wall openings (OPP) may include a center opening (OPPa), a first partition wall opening (OPPb), a second partition wall opening (OPPc), and a third partition wall opening (OPPd). The central opening (OPPa) may also be referred to as a central region (OPPa).

For example, referring to FIG. 3, the partition wall opening (OPP) may include a center opening (OPPa) disposed at the center of the partition wall opening (OPP), a first partition wall opening (OPPb) disposed to extend in a first direction from the center opening (OPPa), a second partition wall opening (OPPc) disposed to extend in a second direction intersecting the first direction from the center opening (OPPa), and a third partition wall opening (OPPd) disposed to extend in a third direction intersecting the first and second directions from the center opening (OPPa). At this time, the first direction, the second direction, and the third direction may be disposed to intersect with each other rather than being parallel to each other. For example, the center opening (OPPa) may have a Y-shape in plan view, and the first partition wall opening (OPPb), the second partition wall opening (OPPc), and the third partition wall opening (OPPd) may each have a rectangular protrusion shape from the end of the center opening (OPPa) (see FIG. 3).

According to one embodiment of the present disclosure, the plurality of subpixels (SP1, SP2, SP3) may be disposed in the first partition wall opening (OPPb), the second partition wall opening (OPPc), and the third partition wall opening (OPPd), respectively. Specifically, referring to FIG. 3, the first subpixel (SP1) may be disposed in the first partition wall opening (OPPb), the second subpixel (SP2) may be disposed in the second partition wall opening (OPPc), and the third subpixel (SP3) may be disposed in the third partition wall opening (OPPd). For example, the plurality of subpixels (SP1, SP2, SP3) may not be disposed in the center opening (OPPa). For example, the plurality of subpixels (SP1, SP2, SP3) may be disposed to be spaced apart from each other in a plane with the center opening (OPPa) therebetween.

According to one embodiment of the present disclosure, the light emitting element (ED) may include a first light emitting element (ED1) disposed in a first subpixel (SP1), a second light emitting element (ED2) disposed in a second subpixel (SP2), and a third light emitting element (ED3) disposed in a third subpixel (SP3). Specifically, the first light emitting element (ED1) may include a first anode electrode (AE1), the second light emitting element (ED2) may include a second anode electrode (AE2), and the third light emitting element (ED3) may include a third anode electrode (AE3). Referring to FIG. 3, the first anode electrode AE1, the second anode electrode AE2, and the third anode electrode AE3 may be disposed in the first subpixel SP1, the second subpixel SP2, and the third subpixel SP3, respectively.

According to one embodiment of the present disclosure, the first anode electrode (AE1), the second anode electrode (AE2), and the third anode electrode (AE3) may be disposed in the first partition wall opening (OPPb), the second partition wall opening (OPPc), and the third partition wall opening (OPPd), respectively. For example, the first anode electrode (AE1), the second anode electrode (AE2), and the third anode electrode (AE3) may be disposed to be spaced apart from each other.

According to one embodiment of the present disclosure, the width of the light emitting opening (OPE) may be smaller than the width of the partition wall opening (OPP). FIG. 4 illustrates an example in which the width of the partition wall opening (OPP) is wider than the width of the light emitting opening (OPE).

According to one embodiment of the present disclosure, the partition wall (105) may include a first partition wall (105a) and a second partition wall (105b) disposed on the first partition wall (105a).

In some embodiments, the partition structure 105 includes at least one partition wall (e.g., a first partition wall 105a, a second partition wall 105b) that defines a compound partition wall opening comprising a central region (OPPa) and multiple directional extensions (e.g., extended shape corresponding to a first partition wall opening (OPPb), a second partition wall opening (OPPc), and a third partition wall opening (OPPd)). The directional extensions extend outward from the central region (OPPa) and are configured to receive subpixels arranged in a spatially separated manner. Each directional extension may extend in a different angular direction from the central region (OPPa), and in some implementations, the extensions are arranged at approximately equal angular intervals (e.g., 120 degrees apart for a three-subpixel configuration). The extensions may have various protruding geometries such as circular, elliptical, triangular, or polygonal shapes. Each directional extension may contain a corresponding subpixel that is physically isolated from adjacent subpixels by the surrounding partition wall structure. This configuration allows for compact and symmetric subpixel layout, facilitating efficient use of display area and precise alignment of the subpixels during manufacturing.

Referring to FIG. 4, the first partition wall (105a) can define a lower partition wall opening (OPP1), and the second partition wall (105b) can define an upper partition wall opening (OPP2). In this case, the upper partition wall opening (OPP2) can be narrower than the lower partition wall opening (OPP1).

For example, the first partition wall (105a) may be relatively recessed compared to the second partition wall (105b). That is, the first partition wall (105a) may be formed in an undercut or reverse taper shape relative to the second partition wall (105b).

The cathode electrode (CE) may correspond to the lower partition wall opening (OPP1). For example, the cathode electrode (CE) may be in contact with the side surface of the first partition wall (105a).

The first partition wall (105a) may be disposed on a pixel defining layer (PDL). The first partition wall (105a) may include a conductive material. The first partition wall (105a) may include a low-resistance metal. For example, the first partition wall (105a) may include gold (Au), silver (Ag), aluminum (Al), magnesium (Mg), lithium (Li), molybdenum (Mo), titanium (Ti), copper (Cu), or an alloy thereof. The thickness of the first partition wall (105a) may be 1000 angstroms or more and 2500 angstroms or less.

The second partition wall (105b) may be disposed on the first partition wall (105a). The second partition wall (105b) may include a region that protrudes toward the partition wall opening (OPP) compared to the first partition wall (105a). However, the second partition wall (105b) may not protrude toward the partition wall opening (OPP) compared to the first partition wall (105a). Specifically, the upper partition wall opening (OPP2) defined by the second partition wall (105b) may have the same width as the lower partition wall opening (OPP1) defined by the first partition wall (105a).

The second partition wall (105b) may include a metal material. The second partition wall (105b) may include gold (Au), silver (Ag), aluminum (Al), magnesium (Mg), lithium (Li), molybdenum (Mo), titanium (Ti), copper (Cu), or an alloy thereof. The second partition wall (105b) may include a different material from the first partition wall (105a). The second partition wall (105b) may include, for example, titanium (Ti). The thickness of the second partition wall (105b) may be 500 angstroms or more and 1000 angstroms or less.

According to one embodiment of the present disclosure, the width of the anode electrode (AE) may be narrower than the width of the lower partition wall opening (OPP1) and wider than the width of the upper partition wall opening (OPP2) (see FIG. 4).

According to one embodiment of the present disclosure, the side surfaces of the first partition wall (105a) and the second partition wall (105b) may be perpendicular to the upper surface of the partition wall (105). That is, the openings of the first partition wall (105a) and the second partition wall (105b) may be the same. However, the present disclosure is not limited thereto. The partition wall (105) may have a tapered shape or a reverse tapered shape.

Generally, a red light emitting layer may be formed in an area corresponding to red subpixels using a fine metal mask (hereinafter referred to as "FMM") in which openings are formed in an area corresponding to red subpixels, a green light emitting layer may be formed in an area corresponding to green subpixels using an FMM in which openings are formed in an area corresponding to green subpixels, and a blue light emitting layer may be formed in an area corresponding to blue subpixels using an FMM in which openings are formed in an area corresponding to blue subpixels. In this case, the light emitting layer may mean an organic light emitting layer.

However, when forming a light emitting layer using FMM, if the precision of the FMM is reduced, interference between subpixels may cause poor color expression of the product.

According to the present disclosure, physical separation between multiple light emitting elements (ED1, ED2, ED3) can be easily achieved by using a partition wall (105) even without using an FMM.

In addition, the organic material, which is the deposition material of the light emitting layer (EL), can be deposited on the substrate by evaporation or sublimation using a deposition device. In particular, in the process of depositing the organic material, the angle at which the deposition material is sprayed and reaches the substrate can be controlled.

At this time, when the partition wall openings (OPP) have a first partition wall opening (OPPb), a second partition wall opening (OPPc), and a third partition wall opening (OPPd) having different directions, when the spraying angle is adjusted so that the red deposition material is disposed at the first partition wall opening (OPPb) to form a red light emitting layer, the red deposition material may not be disposed at the other second partition wall openings (OPPc) and third partition wall openings (OPPd) but may be disposed only at the first partition wall opening (OPPb). In addition, when the spraying angle is adjusted so that the green deposition material is disposed at the second partition wall opening (OPPc) to form a green light emitting layer, the green deposition material may not be disposed at the other first partition wall openings (OPPb) and third partition wall openings (OPPd) but may be disposed only at the second partition wall opening (OPPc). In addition, when adjusting the injection angle so that the blue deposition material is disposed in the third barrier wall opening (OPPd) to form a blue light emitting layer, the blue deposition material may be disposed only in the third barrier wall opening (OPPd) and not in the other first barrier wall openings (OPPb) and second barrier wall openings (OPPc).

As a result, it is possible to obtain multiple light emitting elements (ED1, ED2, ED3) that are physically completely separated without requiring a separate FMM. Accordingly, current leakage or driving errors between the multiple light emitting elements (ED1, ED2, ED3) are prevented, and the multiple light emitting elements (ED1, ED2, ED3) can be driven independently.

In addition, when the partition wall openings (OPP) have a first partition wall opening (OPPb), a second partition wall opening (OPPc), and a third partition wall opening (OPPd) having different directions, and a plurality of subpixels (SP1, SP2, SP3) are disposed in the first partition wall opening (OPPb), the second partition wall opening (OPPc), and the third partition wall opening (OPPd), respectively, the plurality of subpixels (SP1, SP2, SP3) are disposed in one partition wall opening (OPP), thereby reducing the gaps between the plurality of subpixels (SP1, SP2, SP3). As a result, more pixels can be disposed in a display panel (10) having the same area.

Additionally, the pixel defining layer PDL may define a light emitting opening OPE that is aligned with the compound partition wall opening, such that each subpixel is aligned with a respective directional extension in a plan view. In some embodiments, the subpixels are located entirely within the directional extensions and do not overlap the central region (OPPa) of the partition wall opening (OPP). The partition wall (105) may include a multi-layer structure, such as a first (lower) partition wall defining a broader aperture and a second (upper) partition wall defining a narrower aperture. In such configurations, the light emitting element for each subpixel may include an anode, a light emitting layer, and a cathode. The anode may be dimensioned to fit between the lower and upper partition wall apertures, having a lateral dimension (e.g., width) less than that of the lower opening but greater than that of the upper opening. Each light emitting element may be configured to emit a different color of light and is precisely aligned with its corresponding directional extension, supporting full-color pixel implementation without the use of fine metal masks.

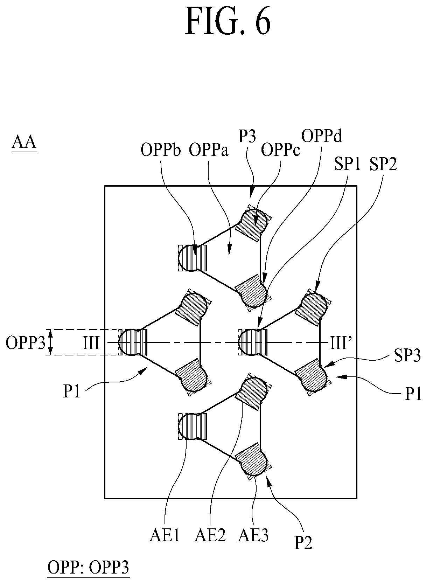

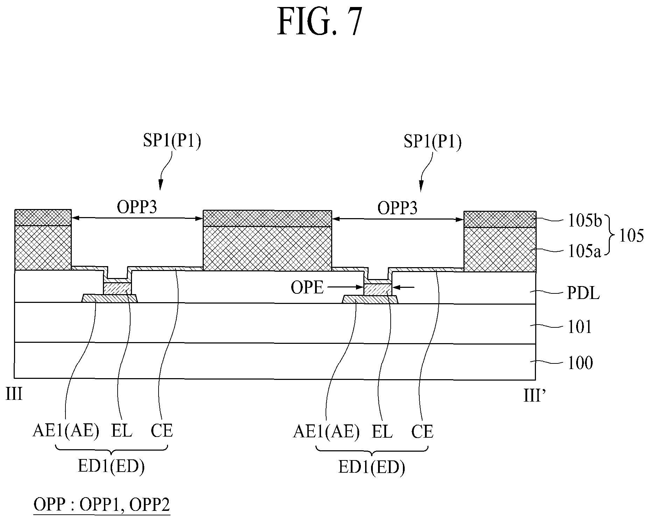

Fig. 6 is an enlarged plan view of a portion of a display area of a display panel according to another embodiment of the present disclosure. Fig. 7 is a cross-sectional view taken along line III-III' of Fig. 6. Descriptions of configurations that overlap with those illustrated in Figs. 1 to 5 among those illustrated in Figs. 6 and 7 are omitted.

According to another embodiment of the present disclosure, the partition wall opening (OPP) may include a third partition wall opening (OPP3). Unlike the partition wall opening (OPP) illustrated in FIGS. 4 and 5, the third partition wall opening (OPP3) may have a constant width (see FIGS. 6, 7 and 8).

Referring to FIGS. 6 and 7, the center opening (OPPa) in a plan view may have a triangular shape, and the first partition wall opening (OPPb), the second partition wall opening (OPPc), and the third partition wall opening (OPPd) may each have a circularly protruding shape from a vertex of the triangular shape.

According to one embodiment of the present disclosure, the first anode electrode (AE1), the second anode electrode (AE2), and the third anode electrode (AE3) may be disposed in the first partition wall opening (OPPb), the second partition wall opening (OPPc), and the third partition wall opening (OPPd), respectively. At this time, since the first partition wall opening (OPPb), the second partition wall opening (OPPc), and the third partition wall opening (OPPd) each have a circularly protruding shape, when the spraying angle is adjusted so that the red deposition material is disposed in the first partition wall opening (OPPb) to form, for example, a red light emitting layer, the red deposition material may be disposed only in the first partition wall opening (OPPb) and not in the other second partition wall openings (OPPc) and third partition wall openings (OPPd). This configuration also applies to the green light emitting layer and the blue light emitting layer.

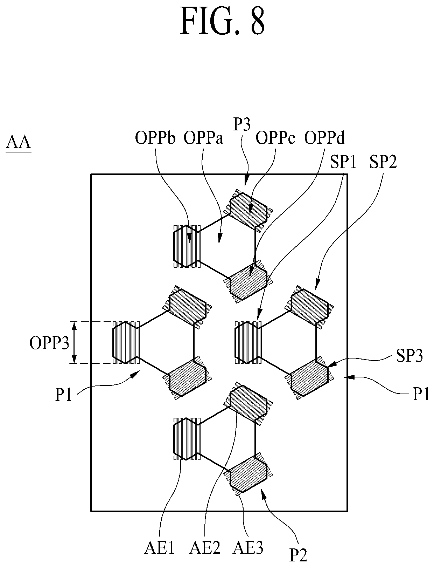

FIG. 8 is an enlarged plan view of a portion of a display area of a display panel according to another embodiment of the present disclosure.

Referring to FIG. 8, the center opening (OPPa) in a plan view has a triangular shape, and the first partition wall opening (OPPb), the second partition wall opening (OPPc), and the third partition wall opening (OPPd) may each have a polygonally protruding shape from a vertex of the triangular shape.

According to one embodiment of the present disclosure, the first anode electrode (AE1), the second anode electrode (AE2), and the third anode electrode (AE3) may be disposed in the first partition wall opening (OPPb), the second partition wall opening (OPPc), and the third partition wall opening (OPPd), respectively. At this time, since the first partition wall opening (OPPb), the second partition wall opening (OPPc), and the third partition wall opening (OPPd) each have a polygonally protruding shape, when the spraying angle is adjusted so that the red deposition material is disposed in the first partition wall opening (OPPb) to form, for example, a red light emitting layer, the red deposition material may be disposed only in the first partition wall opening (OPPb) and not in the other second partition wall openings (OPPc) and third partition wall openings (OPPd). This configuration also applies to the green light emitting layer and the blue light emitting layer.

A method for manufacturing an organic light emitting display apparatus according to one embodiment of the present disclosure may include a step of forming a substrate (100), a step of forming a circuit element layer (101) on the substrate (100), a step of forming an anode electrode (AE) on the circuit element layer (101), a step of forming a pixel defining layer (PDL) on the anode electrode (AE), a step of forming a first partition wall material layer (not shown) and a second partition wall material layer (not shown) on the pixel defining layer (PDL), a step of forming a photoresist layer on the second partition wall material layer (not shown), and a step of forming a partition wall (105) by etching the first partition wall material layer (not shown) and the second partition wall material layer (not shown) using the photoresist layer, and a step of exposing the anode electrode (AE).

According to the present disclosure, the following advantageous effects may be obtained.

An organic light-emitting display device according to one embodiment of the present disclosure can improve defects caused by mask manufacturing or alignment errors by forming a light-emitting layer using a partition wall instead of an FMM.

An organic light emitting display apparatus according to one embodiment of the present disclosure can arrange a large number of subpixels within the same area by reducing the spacing between subpixels.

In addition to the effects mentioned above, other features and advantages of the present disclosure are described below or may be clearly understood by those skilled in the art to which the present disclosure pertains from such description and explanation.

It will be apparent to those skilled in the art that the present disclosure described above is not limited by the above-described embodiments and the accompanying drawings and that various substitutions, modifications and variations can be made in the present disclosure without departing from the spirit or scope of the disclosures. Consequently, the scope of the present disclosure is intended to cover all variations or modifications derived from the meaning, scope and equivalent concept discussed in the present disclosure.

The various embodiments described above can be combined to provide further embodiments. These and other changes can be made to the embodiments in light of the abovedetailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

Also disclosed herein are a number of examples according to the following numbered clauses.

Clause 1. An organic light emitting display apparatus, comprising:
a substrate having a plurality of subpixels;
a pixel defining layer on the substrate;
a light emitting opening within the pixel defining layer;
a partition wall on the pixel defining layer, the partition wall defining a partition wall opening corresponding to the light emitting opening; and
a light emitting element corresponding to the partition wall opening,
wherein the partition wall opening includes:
   a center opening;
   a first partition wall opening disposed to extend in a first direction from the center opening;
   a second partition wall opening disposed to extend in a second direction intersecting the first direction from the center opening; and
   a third partition wall opening disposed to extend in a third direction intersecting the first direction and the second direction from the center opening, respectively,
   wherein the plurality of subpixels are disposed in the first partition wall opening, the second partition wall opening, and the third partition wall opening, respectively.

Clause 2. The organic light emitting display apparatus of Clause 1, wherein the light emitting element includes:
an anode electrode;
a light emitting layer on the anode electrode; and
a cathode electrode on the light emitting layer,
wherein the light emitting layer is in contact with a side surface of the pixel defining layer, and the cathode electrode covers an upper surface of the pixel defining layer.

Clause 3. The organic light emitting display apparatus of Clause 1 or Clause 2, wherein the plurality of subpixels includes a first subpixel, a second subpixel, and a third subpixel, and
wherein the light emitting element includes:
a first light emitting element including a first anode electrode and disposed in the first subpixel;
a second light emitting element including a second anode electrode and disposed in the second subpixel; and
a third light emitting element including a third anode electrode and disposed in the third subpixel.

Clause 4. The organic light emitting display apparatus of Clause 3, wherein the first anode electrode is disposed in the first partition wall opening, the second anode electrode is disposed in the second partition wall opening, the third anode electrode is disposed in the third partition wall opening, and
wherein the first anode electrode, the second anode electrode, and the third anode electrode are disposed spaced apart from each other.

Clause 5. The organic light emitting display apparatus of any preceding Clause, wherein the plurality of subpixels are not disposed in the center opening.

Clause 6. The organic light emitting display apparatus of any preceding Clause, wherein a width of the light emitting opening is smaller than a width of the partition wall opening.

Clause 7. The organic light emitting display apparatus of any preceding Clause, wherein the partition wall includes:
a first partition wall defining a lower partition wall opening; and
a second partition wall defining an upper partition wall opening having a narrower width than the lower partition wall opening, the second partition wall on the first partition wall.

Clause 8. The organic light emitting display apparatus of any preceding Clause, wherein the partition wall includes:
a first partition wall defining a lower partition wall opening; and
a second partition wall defining an upper partition wall opening having a same width as the lower partition wall opening and disposed on the first partition wall.

Clause 9. The organic light emitting display apparatus according to any of Clauses 7 to 8, wherein the first partition wall and the second partition wall each include any one of gold (Au), silver (Ag), aluminum (Al), magnesium (Mg), lithium (Li), molybdenum (Mo), titanium (Ti), copper (Cu), or an alloy thereof.

Clause 10. The organic light emitting display apparatus according to any of Clauses 7 to 9, wherein a thickness of the first partition wall is greater than or equal to 1000 Angstroms and less than or equal to 2500 Angstroms, and a thickness of the second partition wall is greater than or equal to 500 Angstroms and less than or equal to 1000 Angstroms.

Clause 11. The organic light emitting display apparatus according to any of Clauses 7 to 10, wherein the light emitting element includes:
an anode electrode;
a light emitting layer on the anode electrode; and
a cathode electrode on the light emitting layer,
wherein a width of the anode electrode is narrower than a width of the lower partition wall opening and wider than a width of the upper partition wall opening.

Clause 12. The organic light emitting display apparatus of any preceding Clause, wherein the center opening has a Y shape in a plan view.

Clause 13. The organic light emitting display apparatus of Clause 12, wherein the first partition wall opening, the second partition wall opening, and the third partition wall opening have a circularly protruding shape from the center opening in a plan view.

Clause 14. The organic light emitting display apparatus of Clause 12 or Clause 13, wherein the first partition wall opening, the second partition wall opening, and the third partition wall opening have a polygonally protruding shape from the center opening in a plan view.

Clause 15. The organic light emitting display apparatus of any preceding Clause, wherein the center opening has a triangular shape in a plan view.

Clause 16. The organic light emitting display apparatus of Clause 15, wherein the first partition wall opening, the second partition wall opening, and the third partition wall opening have a circularly protruding shape from vertices of the triangular shape in a plan view.

Clause 17. The organic light emitting display apparatus of Clause 15 or Clause 16, wherein the first partition wall opening, the second partition wall opening, and the third partition wall opening have a polygonally protruding shape from vertices of the triangular shape in a plan view.

Clause 18. An organic light emitting display apparatus, comprising:
a plurality of subpixels on a substrate;
a pixel defining layer on the substrate;
a partition structure on the pixel defining layer, the partition structure including at least one partition wall;
a partition wall opening defined by the partition structure, the partition wall opening including a central region and a plurality of directional extensions extending outward from the central region; and
wherein the plurality of subpixels are spatially separated and arranged within the directional extensions of the partition wall opening.

Clause 19. The organic light emitting display apparatus of Clause 18, wherein the plurality of direction extensions extend outward in different angular directions from the central region.

Clause 20. The organic light emitting display apparatus according to any of Clauses 18 to 19, wherein the directional extensions are arranged at approximately equal angular intervals from one another.

Clause 21. The organic light emitting display apparatus according to any of Clauses 18 to 20, wherein each directional extension has a protruding shape selected from circular, elliptical, triangular, or polygonal profiles.

Clause 22. The organic light emitting display apparatus according to any of Clauses 18 to 21, wherein each directional extension contains a subpixel spatially isolated from adjacent subpixels by the partition wall.

Clause 23. The organic light emitting display apparatus according to any of Clauses 18 to 22, wherein the pixel defining layer defines a light emitting opening aligned with the partition wall opening in a plan view.

Clause 24. The organic light emitting display apparatus according to any of Clauses 18 to 23, wherein the plurality of subpixels do not overlap with the central region of the partition wall opening in a plan view.

Clause 25. The apparatus according to any of Clauses 18 to 24, wherein the partition wall includes:
a first partition wall defining a lower partition wall opening; and
a second partition wall on the first partition wall, the second partition wall defining an upper partition wall opening narrower than the lower partition wall opening.

Clause 26. The apparatus of Clause 25, further comprising a light emitting element disposed in each of the plurality of subpixels, each light emitting element comprising an anode, a light emitting layer, and a cathode, and
wherein each light emitting element is configured to emit a different color of light, and each is aligned with a corresponding directional extension.

Clause 27. The apparatus of Clause 26, wherein a lateral dimension of the anode is less than the lower partition opening and greater than the upper partition opening.

## Claims

1. An organic light emitting display apparatus, comprising:
a substrate having a plurality of subpixels;
a pixel defining layer on the substrate;
a light emitting opening within the pixel defining layer;
a partition wall on the pixel defining layer, the partition wall defining a partition wall opening corresponding to the light emitting opening; and
a light emitting element corresponding to the partition wall opening,
wherein the partition wall opening includes:
a center opening;
a first partition wall opening spaced from the center opening in a first direction;
a second partition wall opening spaced from the center opening in a second direction intersecting the first direction ; and
a third partition wall opening spaced from the center opening in a third direction intersecting the first direction and the second direction,
wherein the plurality of subpixels are disposed in the first partition wall opening, the second partition wall opening, and the third partition wall opening, respectively.

2. The organic light emitting display apparatus of claim 1, wherein the light emitting element includes:
an anode electrode;
a light emitting layer on the anode electrode; and
a cathode electrode on the light emitting layer,
wherein the light emitting layer is in contact with a side surface of the pixel defining layer, and the cathode electrode covers an upper surface of the pixel defining layer.

3. The organic light emitting display apparatus of claim 1 or claim 2, wherein the plurality of subpixels includes a first subpixel, a second subpixel, and a third subpixel, and
wherein the light emitting element includes:
a first light emitting element including a first anode electrode and disposed in the first subpixel;
a second light emitting element including a second anode electrode and disposed in the second subpixel; and
a third light emitting element including a third anode electrode and disposed in the third subpixel.

4. The organic light emitting display apparatus of claim 3, wherein the first anode electrode is disposed in the first partition wall opening, the second anode electrode is disposed in the second partition wall opening, the third anode electrode is disposed in the third partition wall opening, and
wherein the first anode electrode, the second anode electrode, and the third anode electrode are disposed spaced apart from each other.

5. The organic light emitting display apparatus of any preceding claim, wherein the plurality of subpixels are not disposed in the center opening.

6. The organic light emitting display apparatus of any preceding claim, wherein a width of the light emitting opening is smaller than a width of the partition wall opening.

7. The organic light emitting display apparatus of any preceding claim, wherein the partition wall includes:
a first partition wall defining a lower partition wall opening; and
a second partition wall defining an upper partition wall opening having a narrower width than the lower partition wall opening, the second partition wall on the first partition wall.

8. The organic light emitting display apparatus according to any of claims 1-6, wherein the partition wall includes:
a first partition wall defining a lower partition wall opening; and
a second partition wall defining an upper partition wall opening having a same width as the lower partition wall opening and disposed on the first partition wall.

9. The organic light emitting display apparatus of claim 7 or claim 8, wherein the first partition wall and the second partition wall each include any one of gold (Au), silver (Ag), aluminum (Al), magnesium (Mg), lithium (Li), molybdenum (Mo), titanium (Ti), copper (Cu), or an alloy thereof.

10. The organic light emitting display apparatus according to any of claims 7 to 9, wherein a thickness of the first partition wall is greater than or equal to 1000 Angstroms and less than or equal to 2500 Angstroms, and a thickness of the second partition wall is greater than or equal to 500 Angstroms and less than or equal to 1000 Angstroms.

11. The organic light emitting display apparatus according to any of claims 7 to 10, wherein the light emitting element includes:
an anode electrode;
a light emitting layer on the anode electrode; and
a cathode electrode on the light emitting layer,
wherein a width of the anode electrode is narrower than a width of the lower partition wall opening and wider than a width of the upper partition wall opening.

12. The organic light emitting display apparatus of any preceding claim, wherein the center opening has a Y shape in a plan view.

13. The organic light emitting display apparatus of claim 12, wherein the first partition wall opening, the second partition wall opening, and the third partition wall opening have a circularly protruding shape from the center opening in a plan view; or wherein the first partition wall opening, the second partition wall opening, and the third partition wall opening have a polygonally protruding shape from the center opening in a plan view.

14. The organic light emitting display apparatus according to any of claims 1 to 11, wherein the center opening has a triangular shape in a plan view.

15. The organic light emitting display apparatus of claim 14, wherein the first partition wall opening, the second partition wall opening, and the third partition wall opening have a circularly protruding shape from vertices of the triangular shape in a plan view; or wherein the first partition wall opening, the second partition wall opening, and the third partition wall opening have a polygonally protruding shape from vertices of the triangular shape in a plan view.
